# EUROPEAN PATENT APPLICATION

(11) **EP 4 604 396 A1**
(43) Date of publication of application: **20.08.2025**
(21) Application number: 24157940.8
(22) Date of filing: 15.02.2024
(51) Int. Cl.: H03K 17/723, H03K 17/74

(54) **THYRISTOR DRIVE CIRCUIT**

(71) Applicant: ABB SCHWEIZ AG, 5400 Baden (CH)
(72) Inventor: JOHANSSON, Björn, 725 92 Västerås (SE); PALM, Staffan, 633 47 Eskilstuna (SE)
(74) Representative: Kransell & Wennborg KB

(57) **Abstract**

A circuit (10) for driving a pair of thyristors (TH1, TH2) comprises a first primary winding (PRW1), a second primary winding (PRW2), a first secondary winding (SEW1) and a second secondary winding (SEW2), where the first and second primary windings (PRW1, PRW2) are connected in series, the first primary winding (PRW1) is magnetically coupled to the first secondary winding (SEW1) and adapted to control a first thyristor (TH1) and the second primary winding (PRW2) is magnetically coupled to the second secondary winding (SEW2) and adapted to control a second thyristor (TH2). The circuit (10) further comprises a voltage source (VS) connected to a junction between a first end of the first primary winding (PRW1) and a first end of the second primary winding (PRW2), a first switch (SWi) connected to a second end of the first primary winding (PRW1) and a second switch (SW2) connected to a second end of the second primary winding (PRW2).

## Description

### FIELD OF THE INVENTION

The present invention relates to a thyristor drive circuit, for instance in a softstarter.

### BACKGROUND

Thyristors are known to be used in softstarters and they may have voltages of at least 690VAC and therefore isolation, for instance using a transformer, is often necessary in relation to the drive circuits used to drive the thyristors.

CN 201120359106 discloses a transformer having a primary winding connected between a voltage source and a motor. The transformer also comprises a second and third secondary winding to which the anodes and cathodes of a first and second thyristor are connected. The thyristors seem to be used for controlling a DC magnetic flux circuit formed through different parts of the core around which the windings are being wound.

GB 1211123 discloses a switching arrangement for providing triggering pulses for controlled rectifiers. In this case there is also a transformer with a first primary winding and a second and third secondary winding, where the anode and gate of a first thyristor are connected to the second winding and the gate and anode of a second thyristor are connected to the third winding. There is also a resonance circuit that is used to generate pulses of different polarity to the first winding.

However, there is still room for improvement in the drive circuit for thyristors, such as in softstarters.

### SUMMARY OF THE INVENTION

The invention therefore aims at providing an improvement thyristor drive circuit.

This object is achieved through a thyristor drive circuit for driving a pair of thyristors. The thyristor drive circuit comprises a first primary winding, a second primary winding, a first secondary winding and a second secondary winding, where the first and second primary windings are connected in series, the first primary winding is magnetically coupled to the first secondary winding and adapted to control a first thyristor of the pair and the second primary winding is magnetically coupled to the second secondary winding and adapted to control a second thyristor of the pair. The thyristor drive circuit further comprises a voltage source connected to a junction between a first end of the first primary winding and a first end of the second primary winding, a first switch connected to a second end of the first primary winding and a second switch connected to a second end of the second primary winding.

The voltage source may be connected between a connection point and the above-mentioned junction, the first switch may be connected between the second end of the first primary winding and the connection point and the second switch may be connected between the second end of the second primary winding and the connection point. In this case it is possible that the voltage source provides a voltage to the junction that is higher than the voltage at the connection point. The connection point may be connected to ground. Alternatively, it is possible that the voltage source provides a voltage to the connection point that is higher than the voltage at the junction. In the latter case it is also possible that the junction is connected to ground.

The thyristor drive circuit may further comprise a signal generation unit operative to generate a first control signal for operating the first switch and a second control signal for operating the second switch, where the first and second control signals may be mutually exclusive.

Thereby, the first switch may be configured to be operated by the first control signal and the second switch may be configured to be operated by the second control signal, which control signals are mutually exclusive.

The first control signal may be set to be operated in a first half of a waveshape applied across the first and second thyristors, while the second control signal may be operated in a second half of the waveshape, which waveshape may be a sinus waveshape.

The first switch may be operative to cause a current to run through the first primary winding when being closed and the second switch may be operable to cause a current to run through the second primary winding when being closed. The current that is caused to run through the first primary winding or the second primary winding may emanate from the voltage source.

The first and second switches may comprise transistors, such as metal-oxide-semiconductor field-effect transistors or bipolar transistors.

The first secondary winding may have a first and second end between which two terminals of the first thyristor are to be connected and the second secondary winding may have a first and second end between which two terminals of the second thyristor are to be connected. Additionally, a third terminal of the first thyristor may be connectable to the second secondary winding and a third terminal of the second thyristor may be connectable to the first secondary winding.

More particularly, a gate of the first thyristor may be connectable to the first end of the first secondary winding, a cathode of the first thyristor may be connectable to the second end of the first secondary winding, a gate of the second thyristor may be connectable to the first end of the second secondary winding and a cathode of the second thyristor may be connectable to the second end of the second secondary winding. Additionally, an anode of the first thyristor may optionally be connectable to the second end of the second secondary winding and an anode of the second thyristor may be connectable to the second end of the first secondary winding.

The thyristor drive circuit may also comprise a first diode and a second diode, where the first diode may be connected between the first secondary winding and one of the previously-mentioned two terminals of the first thyristor and the second diode may be connected between the second secondary winding and one of the previously-mentioned two terminals of the second thyristor.

The first diode may be connected between the first end of the first secondary winding and the above-mentioned one of the two terminals of the first thyristor and the second diode may be connected between the first end of the second secondary winding and the above-mentioned one of the two terminals of the second thyristor. More particularly, the anode of the first diode may be connected to the first end of the first secondary winding and the cathode of the first diode may be connected to the gate of the first thyristor, while the anode of the second diode may be connected to the first end of the second secondary winding and the cathode of the second diode may be connected to the gate of the second thyristor.

Alternatively, the first diode may be connected between the second end of the first secondary winding and the above-mentioned one of the two terminals of the first thyristor and the second diode may be connected between the second end of the second secondary winding and the above-mentioned one of the two terminals of the second thyristor. More particularly, the cathode of the first diode may be connected to the second end of the first secondary winding and the anode of the first diode may be connected to the cathode of the first thyristor, while the cathode of the second diode may be connected to the second end of the second secondary winding and the anode of the second diode may be connected to the cathode of the second thyristor.

The thyristor drive circuit may also comprise a first filter connected in parallel with the previously-mentioned two terminals of the first thyristor and a second filter capacitor connected in parallel with the previously-mentioned two terminals of the second thyristor. Such a filter may comprise a capacitor and/or a resistor.

The primary and secondary windings may be included in a transformer stage.

In a first transformer stage realization, the first primary winding may be magnetically coupled to the first secondary winding and the second primary winding may be magnetically coupled to the second secondary winding, where the magnetic coupling between the first primary winding and the first secondary winding may be such that a current entering the first end of the first primary winding causes a positive voltage at the first end of the first secondary winding and the magnetic coupling between the second primary winding and the second secondary winding may be such that a current entering the second end of the second primary winding causes a positive voltage at the second end of the first secondary winding.

In the first transformer stage realization, the first primary winding may also be magnetically coupled to the second secondary winding and the second primary winding may be magnetically coupled to the first secondary winding, where the magnetic coupling between the first primary winding and the second secondary winding may be such that a current entering the first end of the first primary winding causes a positive voltage at the second end of second secondary winding and the magnetic coupling between the second primary winding and the first secondary winding may be such that a current entering the second end of the second primary winding causes a positive voltage at the first end of the first secondary winding.

For the first transformer stage realization, it is also possible that the voltage source provides a voltage to the junction between the first and second primary windings that is higher than the voltage at the connection point.

In a second transformer stage realization, the first primary winding may be magnetically coupled to the first secondary winding and the second primary winding may be magnetically coupled to the second secondary winding, where the magnetic coupling between the first primary winding and the first secondary winding is such that a current entering the first end of the first primary winding causes a positive voltage at the second end of the first secondary winding and the magnetic coupling between the second primary winding and the second secondary winding is such that a current entering the second end of the second primary winding causes a positive voltage at the first end of the first secondary winding.

In the second transformer stage realization, the first primary winding may be magnetically coupled to the second secondary winding and the second primary winding may be magnetically coupled to the first secondary winding, where the magnetic coupling between the first primary winding and the second secondary winding is such that a current entering the first end of the first primary winding causes a positive voltage at the first end of the second secondary winding and the magnetic coupling between the second primary winding and the first secondary winding is such that a current entering the second end of the second primary winding causes a positive voltage at the second end of the first secondary winding.

For the second transformer stage realization, it is additionally possible that the voltage source provides a voltage to the connection point that is higher than the voltage at the junction between the first and second primary windings.

The first primary winding and the first secondary winding may be provided in a first transformer, while the second primary winding and the second secondary winding may be provided in a second transformer. Alternatively, the first primary winding, the second primary winding, the first secondary winding and the second secondary winding may be provided in the same transformer, where the first and second primary windings may be parts of a common primary winding, with the voltage source being connected to the midpoint of this common primary winding.

### BRIEF DESCRIPTION OF THE DRAWINGS

The present invention will in the following be described with reference being made to the accompanying drawings, where
Fig. 1 schematically shows a signal generation unit and a first variation of a thyristor drive circuit for driving a pair of thyristors, which thyristor drive circuit comprises a first and a second switch, and
Fig. 2 schematically shows the signal generation unit and a second variation of the thyristor drive circuit.

### DETAILED DESCRIPTION OF THE INVENTION

In the following there will be given a detailed description of embodiments of a thyristor drive circuit for driving a pair of thyristors.

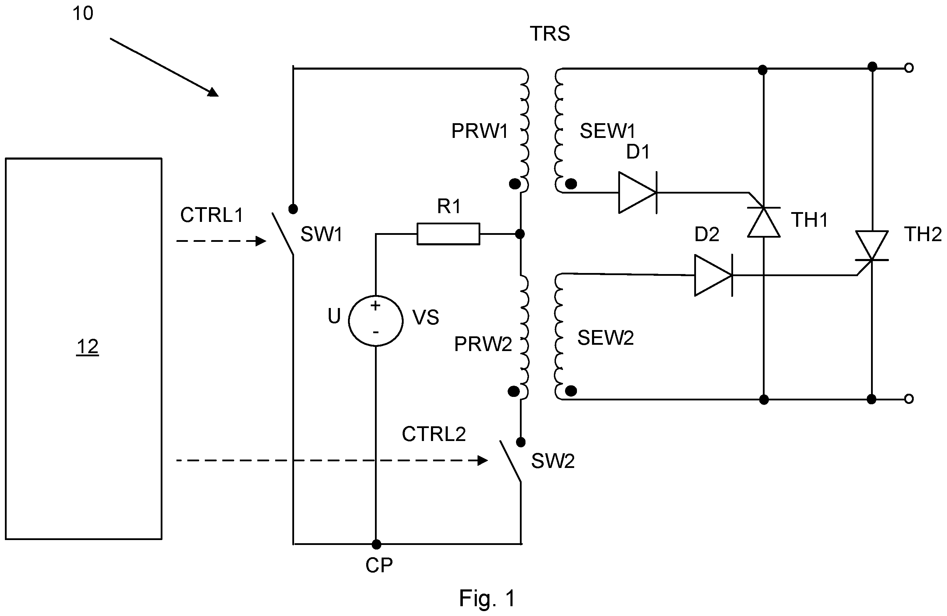

Fig. 1 schematically shows a signal generation unit 12 and a first variation of a thyristor drive circuit 10 for driving a pair of thyristors TH1, TH2. The thyristor drive circuit 10 comprises a transformer stage TRS comprising a first primary winding PRW1, a second primary winding PRW2, a first secondary winding SEW1 and a second secondary winding SEW2 and the first and second primary windings PRW1, PRW2 are connected in series. Furthermore, the first primary winding PRW1 is magnetically coupled to the first secondary winding SEW1 and the second primary winding PRW2 is magnetically coupled to the second secondary winding SEW2.

In the shown embodiment the transformer stage TRS is formed through one single transformer and thereby the first and second primary windings PRW1, PRW2 may be a first and second half of a single primary winding. They may be parts of a common primary winding. Furthermore, the first primary winding PRW1 is adapted to control a first thyristor TH1 in the pair of thyristors, while the second primary winding PRW2 is adapted to control a second thyristor TH2 in the pair of thyristors. The thyristors TH1, TH2 may additionally be included in a softstarter for controlling a motor or a transformer.

The first secondary winding SEW1 has a first and second end between which two terminals of the first thyristor TH1 are connected and the second secondary winding SEW2 has a first and second end between which two terminals of the second thyristor TH2 are connected. A third terminal of the first thyristor TH1 may be connected to the second secondary winding SEW2, while a third terminal of the second thyristor TH2 may be connected to the first secondary winding SEW1.

As is well known, a thyristor has three terminals; an anode, a cathode, and a gate. In the present case the gate of the first thyristor TH1 is connected to the first end of the first secondary winding SEW1, the cathode of the first thyristor TH1 is connected to the second end of the first secondary winding SEW1 and the anode of the first thyristor TH1 is connected to the second end of the second secondary winding SEW2. The gate of the second thyristor TH2 is in turn connected to the first end of the second secondary winding SEW2, the cathode of the second thyristor TH2 is connected to the second end of the second secondary winding SEW2 and the anode of the second thyristor TH2 is connected to the second end of the first secondary winding SEW1. It should here be realized that the connection of the anode of the first thyristor TH1 to the second secondary winding SEW2 and the connection of the anode of the second thyristor TH2 to the first secondary winding SEW2 are not essential for the functioning of the thyristor drive circuit. In fact, they can be connected in several different ways.

In the shown embodiment there is also a first diode D1 and a second diode D2. The first diode D1 is connected between the first secondary winding SEW1 and one of the previously-mentioned two terminals of the first thyristor TH1 and the second diode D1 is connected between the second secondary winding SEW2 and one of the previously-mentioned two terminals of the second thyristor TH2. In the present example the first diode D1 is connected between the first end of the first secondary winding SEW1 and the above-mentioned one of the two terminals of the first thyristor TH1 and the second diode D2 is connected between the first end of the second secondary winding SEW2 and the above-mentioned one of the two terminals of the second thyristor TH2. More particularly, the first diode D1 has an anode connected to the first end of the first secondary winding SEW1 and a cathode connected to the gate of the first thyristor TH1, while the second diode D2 has an anode connected to the first end of the second secondary winding SEW2 and a cathode connected to the gate of the second thyristor TH2. Thereby the first end of the first secondary winding SEW1 is connected to the gate of the first thyristor TH1 via the first diode D1 and the first end of the second secondary winding SEW2 is connected to the gate of the second thyristor TH2 via the second diode D2.

It is also possible that there is a first filter connected in parallel with the gate and cathode of the first thyristor TH1 and a second filter connected in parallel with the gate and cathode of the second thyristor TH2 (not shown), where such a filter may comprise a capacitor and/or a resistor. The thyristor drive circuit 10 also comprises a voltage source VS connected to a junction between a first end of the first primary winding PRW1 and a first end of the second primary winding PRW2, a first switch SW1 connected to a second end of the first primary winding PRW1 and a second switch SW2 connected to a second end of the second primary winding PRW2. If the first and second primary windings are parts of a common primary winding, the voltage source VS may be connected to the midpoint of this common primary winding.

More particularly, the voltage source VS may be connected between a connection point CP and the junction between the first end of the first primary winding PRW1 and the first end of the second primary winding PRW2. In the present case the voltage source VS, which is a direct current (DC) voltage source, is connected to the junction via a first resistor R1. It should be realized that the first resistor R1 is optional. A negative terminal of the voltage source VS is connected to the connection point CP and a positive terminal of the voltage source VS is connected to the first resistor R1. The first switch SW1 may in turn be connected between the second end of the first primary winding PRW1 and the connection point CP and the second switch SW2 may be connected between the second end of the second primary winding PRW2 and the connection point. In this case the voltage source VS provides a voltage U to the above-mentioned junction that is higher than the voltage at the connection point CP.

Furthermore, the connection point CP may be grounded, in which case the voltage source VS provides a positive voltage U to the above-mentioned junction. It should here be realized that the first and second switches Sw1, SW2 are not necessarily connected to ground. It is sufficient that they are connected to an electric potential that is lower than the voltage of the voltage source VS.

The first and second switches SW1, SW2 may be realized using transistors. They may for instance be realized using metal-oxide-semiconductor field-effect transistors (MOSFETs). The first and second switch may thereby comprise MOSFET transistors.

It should here be realized that it is possible with other types of transistors than MOSFETs. It is for instance possible to use Bipolar Transistors instead.

The first primary winding PRW1 is magnetically coupled to the first secondary winding SEW1 and the second primary winding PRW2 is magnetically coupled to the second secondary winding SEW2, where the magnetic coupling between the first primary winding PRW1 and the first secondary winding SEW1 is such that a current entering the first end of the first primary winding PRW1 causes a positive voltage at the first end of the first secondary winding SEW1 and the magnetic coupling between the second primary winding PRW2 and the second secondary winding SEW2 is such that a current entering the second end of the second primary winding PRW2 causes a positive voltage at the second end of the second secondary winding SEW2.

In the present example the first primary winding PRW1 is also magnetically coupled to the second secondary winding SEW2 and the second primary winding PRW2 is magnetically coupled to the first secondary winding SEW1. In this case the magnetic coupling between the first primary winding PRW1 and the second secondary winding SEW2 is such that a current entering the first end of the first primary winding PRW1 causes a positive voltage at the second end of second secondary winding SEW2 and the magnetic coupling between the second primary winding PRW2 and the first secondary winding SEW1 is such that a current entering the second end of the second primary winding PRW2 causes a positive voltage at the first end of the first secondary winding SEW1.

The magnetic coupling described above is shown using dots applied according to the dot convention. Consequently, the first end of the first primary winding PRW1 is provided with a first dot, the second end of the second primary winding PRW2 is provided with a second dot, the first end of the first secondary winding SEW1 is provided with a third dot and the second end of the second secondary winding SEW2 is provided with a fourth dot.

As can be seen in fig. 1, the first switch SW1 is operated by a first control signal CTRL1, while the second switch SW2 is operated with a second control signal CTRL2.

The signals may be generated by the signal generation unit 12. The signal generation unit may thus generate the first control signal CTRL1 for operating the first switch SW1 and the second control signal CTRL2 for operating the second switch SW2.

The first and second control signals CTRL1, CTRL2 may vary between a high and a low level or between a positive and a negative level. They may also be mutually exclusive in that the second switch SW2 is never turned on and conducting when the first switch SW1 is turned on and conducting and vice versa. Thereby, the first switch SW1 may be configured to be operated by the first control signal CTRL1 and the second switch SW2 may be configured to be operated by the second control signal CTRL2, which control signals are mutually exclusive.

Additionally, the first control signal CTRL1 may be set to be operated in a first half of a waveshape applied across the first and second thyristors TH1, TH2, while the second control signal CTRL2 may be operated in a second half of the waveshape, which waveshape may be a sinus waveshape.

When the first switch SW1 is closed, a voltage U of the voltage source VS will cause a current to run through the first primary winding PRW1, which current enters the first primary winding PRW1 via the first end of the first primary winding PRW1. The current that is caused to run through the first primary winding PRW1 thus emanates from the voltage source VS. Due to the magnetic coupling between the first primary winding PRW1 and the first secondary winding SEW1, the first primary winding PRW1 will cause a positive voltage to appear at the first end of the first secondary winding SEW1, which will fire the first thyristor TH1.

Due to the magnetic coupling between the first primary winding PRW1 and the second secondary winding SEW2, the first primary winding PRW1 will cause a positive voltage to appear at the second end of the second secondary winding SEW2. However, the second diode D2 will in this case block this voltage and therefore the second thyristor TH2 will not be fired.

When the second switch SW2 is closed, the voltage U of the voltage source VS will cause a current to run through the second primary winding PRW2, which current enters the second primary winding PRW2 via the first end of the second primary winding PRW2. The current that is caused to run through the second primary winding PRW2 thus emanates from the voltage source VS. Due to the magnetic coupling between the second primary winding PRW2 and the second secondary winding SEW2, the second primary winding PRW2 will cause a positive voltage to appear at the first end of the second secondary winding SEW2. This will fire the second thyristor TH2.

Due to the magnetic coupling between the second primary winding PRW2 and the first secondary winding SEW1, the second primary winding PRW2 will cause a positive voltage to appear at the second end of the first secondary winding SEW1. However, the first diode D1 will in this case block the voltage and therefore the first thyristor TH1 will not be fired.

It can thereby be seen that the thyristors TH1, TH2 may be driven by a thyristor drive circuit comprising one voltage source and one transformer with two secondary windings. Thereby the thyristor drive circuit may be made compact, while at the same time only firing one thyristor at a time. The current consumption may thereby also be low.

The use of the first and second diodes improves the control in that only the primary winding that is intended to be used to influence the firing is allowed to do so.

It should here be realized that as an alternative it is possible to implement the thyristor drive circuit using two transformers, in which case the first primary winding and first secondary winding would be provided in one transformer and the second primary winding and second secondary winding would be provided in a second transformer.

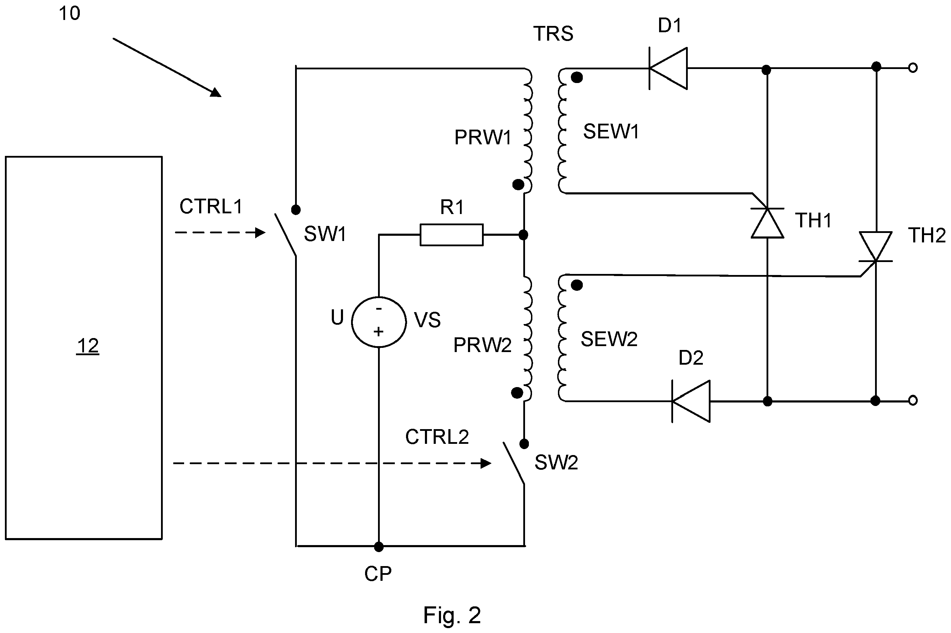

A second variation is shown in fig. 2. In this case the first diode D1 is connected between the second end of the first secondary winding SEW1 and the previously-mentioned one of the two terminals of the first thyristor TH1 and the second diode D2 is connected between the second end of the second secondary winding SW2 and the previously-mentioned one said one of the two terminals of the second thyristor TH2. Thus, the second end of the first secondary winding SEW1 is connected to the cathode of the first thyristor TH1 via the first diode D1 and the second end of the second secondary winding SEW2 is connected to the cathode of the second thyristor TH2 via the second diode D2. In the present case, the cathode of the first diode D1 is connected to the second end of the first secondary winding SEW1 and the anode of the first diode D1 is connected to the cathode of the first thyristor TH1, while the cathode of the second diode D2 is connected to the second end of the second secondary winding SEW2 and the anode of the second diode D2 is connected to the cathode of the second thyristor TH2.

In the second variation the orientation of the voltage source VS has been changed compared with fig. 1. In this case the voltage source VS provides a voltage U to the connection point CP that is higher than the voltage at the junction. In this case the junction may be grounded. The voltage source VS may additionally provide a positive voltage U to the connection point CP.

Furthermore, in the second variation the realization of the transformer stage is different. In this case, the magnetic coupling between the first primary winding PRW1 and the first secondary winding SEW1 is such that a current entering the first end of the first primary winding PRW1 causes a positive voltage at the second end of the first secondary winding SEW1 and the magnetic coupling between the second primary winding PRW2 and the second secondary winding SEW2 is such that a current entering the second end of the second primary winding PRW2 causes a positive voltage at the first end of the first secondary winding SEW2.

Moreover, where the magnetic coupling between the first primary winding PRW1 and the second secondary winding SEW2 is such that a current entering the first end of the first primary winding PRW1 causes a positive voltage at the first end of the second secondary winding SEW2 and the magnetic coupling between the second primary winding PRW2 and the first secondary winding SEW1 is such that a current entering the second end of the second primary winding PRW2 causes a positive voltage at the second end of the first secondary winding SEW1.

It should here be realized that the diodes of this second variation could have the same orientation and placing as in the first variation. It is also possible that the diodes of the first variation could have the same orientation and placing as in the second variation.

## Claims

1. A thyristor drive circuit (10) for driving a pair of thyristors (TH1, TH2), the thyristor drive circuit (10) comprising a first primary winding (PRW1), a second primary winding (PRW2), a first secondary winding (SEW1) and a second secondary winding (SEW2), where the first and second primary windings (PRW1, PRW2) are connected in series, the first primary winding (PRW1) is magnetically coupled to the first secondary winding (SEW1) and adapted to control a first thyristor (TH1) of the pair and the second primary winding (PRW2) is magnetically coupled to the second secondary winding (SEW2) and adapted to control a second thyristor (TH2) of the pair,
the thyristor drive circuit (10) further comprising a voltage source (VS) connected to a junction between a first end of the first primary winding (PRW1) and a first end of the second primary winding (PRW2), a first switch (SW1) connected to a second end of the first primary winding (PRW1) and a second switch (SW2) connected to a second end of the second primary winding (PRW2).

2. The thyristor drive circuit (10) according to claim 1, wherein the first switch (SW1) is configured to be operated by a first control signal (CTRL1) and the second switch (SW2) is configured to be operated by a second control signal (CTRL2), which control signals (CTRL1, CTRL2) are mutually exclusive.

3. The thyristor drive circuit (10) according to claim 1 or 2, wherein the first switch (SW1) is operative to cause a current to run through the first primary winding (PRW1) when being closed and the second switch (SW2) is operable to cause a current to run through the second primary winding (PRW2) when being closed.

4. The thyristor drive circuit (10) according to any previous claim, wherein the first secondary winding (SEW1) has a first and second end between which two terminals of the first thyristor (TH1) are to be connected and the second secondary winding (SEW2) has a first and second end between which two terminals of the second thyristor (TH2) are to be connected.

5. The thyristor drive circuit (10) according to claim 4, wherein a gate of the first thyristor (TH1) is to be connected to the first end of the first secondary winding (SEW1), a cathode of the first thyristor (TH1) is to be connected to the second end of the first secondary winding (SEW1), a gate of the second thyristor (TH2) is to be connected to the first end of the second secondary winding (SEW2) and a cathode of the second thyristor (TH2) is to be connected to the second end of the second secondary winding (SEW2).

6. The thyristor drive circuit (10) according to claim 4 or 5, further comprising a first diode and a second diode (D1, D2), the first diode (D1) being connected between the first secondary winding (SEW1) and one of said two terminals of the first thyristor (TH1) and the second diode (D2) being connected between the second secondary winding (SEW2) and one of said two terminals of the second thyristor (TH2).

7. The thyristor drive circuit (10) according to claim 6, wherein the first diode (D1) is connected between the first end of the first secondary winding (SEW1) and said one of said two terminals of the first thyristor (TH1) and the second diode (D2) is connected between the first end of the second secondary winding (SW2) and said one of said two terminals of the second thyristor (TH2).

8. The thyristor drive circuit (10) according to claim 7, wherein the anode of the first diode (D1) is connected to the first end of the first secondary winding (SEW1) and the cathode of the first diode (D1) is connected to the gate of the first thyristor (TH1), while the anode of the second diode (D2) is connected to the first end of the second secondary winding (SEW2) and the cathode of the second diode (D2) is connected to the gate of the second thyristor (TH2).

9. The thyristor drive circuit (10) according to claim 6, wherein the first diode (D1) is connected between the second end of the first secondary winding (SEW1) and said one of said two terminals of the first thyristor (TH1) and the second diode (D2) is connected between the second end of the second secondary winding (SW2) and said one of said two terminals of the second thyristor (TH2).

10. The thyristor drive circuit (10) according to claim 9, wherein the cathode of the first diode (D1) is connected to the second end of the first secondary winding (SEW1) and the anode of the first diode (D1) is connected to the cathode of the first thyristor (TH1), while the cathode of the second diode (D2) is connected to the second end of the second secondary winding (SEW2) and the anode of the second diode (D2) is connected to the cathode of the second thyristor (TH2).

11. The thyristor drive circuit (10) according to any of claims 4 - 10, wherein the first primary winding (PRW1) is magnetically coupled to the first secondary winding (SEW1) and the second primary winding (PRW2) is magnetically coupled to the second secondary winding (SEW2), where the magnetic coupling between the first primary winding (PRW1) and the first secondary winding (SEW1) is such that a current entering the first end of the first primary winding (PRW1) causes a positive voltage at the first end of the first secondary winding (SEW1) and the magnetic coupling between the second primary winding (PRW2) and the second secondary winding (SEW2) is such that a current entering the second end of the second primary winding (PRW2) causes a positive voltage at the second end of the first secondary winding (SEW2).

12. The thyristor drive circuit (10) (10) according to claim 11, wherein the first primary winding (PRW1) is magnetically coupled to the second secondary winding (SEW2) and the second primary winding (PRW2) is magnetically coupled to the first secondary winding (SEW1), where the magnetic coupling between the first primary winding (PRW1) and the second secondary winding (SEW2) is such that a current entering the first end of the first primary winding (PRW1) causes a positive voltage at the second end of second secondary winding (SEW2) and the magnetic coupling between the second primary winding (PRW2) and the first secondary winding (SEW1) is such that a current entering the second end of the second primary winding (PRW2) causes a positive voltage at the first end of the first secondary winding (SEW1).

13. The thyristor drive circuit (10) according to any of claims 4 - 10, wherein the first primary winding (PRW1) is magnetically coupled to the first secondary winding (SEW1) and the second primary winding (PRW2) is magnetically coupled to the second secondary winding (SEW2), where the magnetic coupling between the first primary winding (PRW1) and the first secondary winding (SEW1) is such that a current entering the first end of the first primary winding (PRW1) causes a positive voltage at the second end of the first secondary winding (SEW1) and the magnetic coupling between the second primary winding (PRW2) and the second secondary winding (SEW2) is such that a current entering the second end of the second primary winding (PRW2) causes a positive voltage at the first end of the first secondary winding (SEW2).

14. The thyristor drive circuit (10) (10) according to claim 13, wherein the first primary winding (PRW1) is magnetically coupled to the second secondary winding (SEW2) and the second primary winding (PRW2) is magnetically coupled to the first secondary winding (SEW1), where the magnetic coupling between the first primary winding (PRW1) and the second secondary winding (SEW2) is such that a current entering the first end of the first primary winding (PRW1) causes a positive voltage at the first end of the second secondary winding (SEW2) and the magnetic coupling between the second primary winding (PRW2) and the first secondary winding (SEW1) is such that a current entering the second end of the second primary winding (PRW2) causes a positive voltage at the second end of the first secondary winding (SEW1).

15. The thyristor drive circuit (10) according to any of claims 1 - 14, wherein the first primary winding (PRW1), the second primary winding (PRW2), first secondary winding (SEW1) and second secondary winding (SEW2) are provided in the same transformer, where the first and second primary windings (PRW1, PRW2) are parts of a common primary winding.
